# EUROPEAN PATENT APPLICATION

(11) **EP 4 822 431 A1**
(43) Date of publication of application: **14.10.2026**
(21) Application number: 24924940.0
(22) Date of filing: 10.12.2024
(51) Int. Cl.: G02F 1/1333

(54) **DISPLAY APPARATUS**

(30) Priority: 14.02.2024 KR 20240021372
(71) Applicant: Samsung Electronics Co., Ltd., Suwon-si, Gyeonggi-do 16677 (KR)
(72) Inventor: PARK, Jin, Suwon-si Gyeonggi-do 16677 (KR); MOON, Jaesic, Suwon-si Gyeonggi-do 16677 (KR); PARK, Sungyong, Suwon-si Gyeonggi-do 16677 (KR); PARK, Chulsoon, Suwon-si Gyeonggi-do 16677 (KR); IN, Sehwan, Suwon-si Gyeonggi-do 16677 (KR)
(74) Representative: Appleyard Lees IP LLP
(86) International application number: PCT/KR2024/096643
(87) International publication number: WO 2025/173916

(57) **Abstract**

Disclosed herein is a display apparatus. The display apparatus includes a display panel, a circuit board configured to control the display panel, a bottom chassis configured to support the circuit board, and a board holder configured to secure the circuit board to the bottom chassis. The board holder includes a holder body secured to the bottom chassis, a catch portion configured to be elastically deformed to be movably supported on the holder body when an external force is applied, and provided to support one surface of the circuit board, and a pressing portion configured to be elastically deformed to be movable relative to the holder body when an external force is applied, and provided to press the other surface of the circuit board toward the catch portion.

## Description

### [TECHNICAL FIELD]

The disclosure relates to a display apparatus.

### [BACKGROUND ART]

In general, a display apparatus is a type of output device that converts acquired or stored electrical information into visual information and displays such information to a user, and is used in various fields such as homes and businesses.

The display apparatus may include, for example, a monitor device connected to a personal computer (PC) or a server computer, a portable computer device, a navigation terminal device, a conventional television device, an Internet Protocol television (IPTV) apparatus, a handheld terminal device such as a smart phone, tablet PC, personal digital assistant (PDA), or cellular phone, various display devices used for playing images such as advertisements or movies in industrial sites, or various other types of audio/video systems.

The display apparatus may utilize a self-emissive display panel, such as an organic light-emitting diode (OLED) panel or a non-emissive display panel, such as a liquid crystal display (LCD) panel.

The display apparatus includes various circuit boards, such as a main board, a switched mode power supply (SMPS) board, a source board, and the like.

### [DISCLOSURE]

### [TECHNICAL PROBLEM]

An aspect of the present disclosure provides a display apparatus having an improved structure allowing circuit boards of various thicknesses to be mounted on a bottom chassis.

An aspect of the present disclosure provides a display apparatus having an improved structure in which a circuit board mounted on a bottom chassis is reliably secured.

An aspect of the present disclosure provides a display apparatus having an improved structure allowing a circuit board to be efficiently and easily mounted on a bottom chassis.

An aspect of the present disclosure provides a display apparatus having an improved structure to automate a process of mounting a circuit board on a bottom chassis.

Technical tasks to be achieved in the present document are not limited to the technical tasks mentioned above, and other technical tasks not mentioned will be clearly understood by those skilled in the art from the description below.

### [Technical Solution]

A display apparatus according to an embodiment of the present disclosure includes a display panel, a source board configured to control the display panel, a bottom chassis configured to support the source board, and a board holder configured to secure the source board to the bottom chassis. The board holder includes a holder body secured to the bottom chassis, a catch portion connected to the holder body and configured to support one surface of the source board opposite to the bottom chassis, and a pressing portion connected to the holder body, configured to be elastically deformed to move relative to the holder body when an external force is applied, and configured to press the other surface of the source board facing the bottom chassis toward the catch portion.

A display apparatus according to an embodiment of the present disclosure includes a display panel, a circuit board configured to control the display panel, a bottom chassis configured to support the display panel and the circuit board, and a board holder disposed on the bottom chassis and to which the circuit board is mounted. The board holder includes a first catch portion configured to support one surface of the circuit board opposite to the bottom chassis, a second catch portion opposing the first catch portion and configured to support the one surface of the circuit board, a first pressing portion configured to be elastically deformable and to press the other surface of the circuit board in a direction away from the bottom chassis, and a second pressing portion opposing the first pressing portion, provided to be elastically deformable, and configured to press the other surface of the circuit board in a direction away from the bottom chassis.

A display apparatus according to an embodiment of the present disclosure includes a display panel, a circuit board configured to control the display panel, a bottom chassis configured to support the circuit board, and a board holder configured to secure the circuit board to the bottom chassis. The board holder includes a holder body secured to the bottom chassis, a catch portion configured to be elastically deformed to be movably supported on the holder body when an external force is applied, and provided to support one surface of the circuit board, and a pressing portion configured to be elastically deformed to be movable relative to the holder body when an external force is applied, and provided to press the other surface of the circuit board toward the catch portion.

### [DESCRIPTION OF DRAWINGS]

FIG. 1 is a perspective view illustrating a display apparatus according to an embodiment of the present disclosure.
FIG. 2 is an exploded view illustrating the display apparatus according to an embodiment of the present disclosure.
FIG. 3 is a view illustrating some configurations, such as a bottom chassis and a source board, of the display apparatus according to an embodiment of the present disclosure from the rear.
FIG. 4 is an enlarged view illustrating portion A of FIG. 3.
FIG. 5 is an exploded view of the bottom chassis, the board holder, and the source board shown in FIG. 4.
FIG. 6 is a perspective view illustrating a board holder included in the display apparatus according to an embodiment of the present disclosure, viewed from one direction.
FIG. 7 is a perspective view illustrating the board holder included in the display apparatus according to an embodiment of the present disclosure, viewed from another direction.
FIG. 8 is a perspective view illustrating the board holder included in the display apparatus according to an embodiment of the present disclosure, viewed from another direction.
FIG. 9 is a view illustrating a state before a source board is mounted to the board holder included in the display apparatus according to an embodiment of the present disclosure.
FIG. 10 is a view illustrating a state in which a source board of a first thickness is mounted to the board holder included in the display apparatus according to an embodiment of the present disclosure.
FIG. 11 is a view illustrating a state in which a source board of a second thickness is mounted to the board holder included in the display apparatus according to an embodiment of the present disclosure.
FIG. 12 is a cross-sectional view illustrating an example of a process of coupling a board holder to a bottom chassis of a display apparatus according to an embodiment of the present disclosure.
FIG. 13 is a cross-sectional view illustrating a state in which the board holder is coupled to the bottom chassis by the process of FIG. 12.
FIG. 14 is a view illustrating an example of a process of mounting a source board to a board holder of a display apparatus according to an embodiment of the present disclosure.
FIG. 15 is a view illustrating a state in which the source board is mounted to the board holder by the process of FIG. 14.
FIG. 16 is a view illustrating another example of a process of mounting a source board to a board holder of a display apparatus according to an embodiment of the present disclosure.
FIG. 17 is a view illustrating a state in which the source board is mounted to the board holder by the process of FIG. 16.

### [MODES OF THE INVENTION]

Various embodiments of the disclosure and terms used herein are not intended to limit the technical features described herein to specific embodiments, and should be understood to include various modifications, equivalents, or substitutions of the corresponding embodiments.

In describing of the drawings, similar reference numerals may be used for similar or related elements.

The singular form of a noun corresponding to an item may include one or more of the items unless clearly indicated otherwise in a related context.

In the disclosure, phrases, such as "A or B", "at least one of A and B", "at least one of A or B", "A, B or C", "at least one of A, B and C", and "at least one of A, B, or C" may include any one or all possible combinations of the items listed together in the corresponding phrase among the phrases.

In addition, the terms "portion", "unit", "part", "module" and "member" may be implemented in hardware or software. Depending on embodiments, a plurality of "portions", "units", "parts", "modules" and "members" may be implemented as a single element, or a single "portion", "unit", "part", "module" or "member" may include a plurality of elements.

Also, the terms used herein are used to describe the embodiments and are not intended to limit and/or restrict the disclosure. The singular forms "a," "an" and "the" are intended to include the plural forms as well, unless the context clearly indicates otherwise. In this disclosure, the terms "including", "having", and the like are used to specify features, figures, steps, operations, elements, configurations, or combinations thereof, but do not preclude the presence or addition of one or more of the features, figures, steps, operations, elements, configurations, or combinations thereof.

It will be understood that, although the terms "first", "second", "primary", "secondary", etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

When an element (e.g., a first element) is referred to as being "(functionally or communicatively) coupled" or "connected" to another element (e.g., a second element), the first element may be connected to the second element, directly (e.g., wired), wirelessly, or through a third element.

When an element is said to be "connected", "coupled", "supported" or "contacted" with another element, this includes not only when elements are directly connected, coupled, supported or contacted, but also when elements are indirectly connected, coupled, supported or contacted through a third element.

Throughout the description, when an element is "on" another element, this includes not only when the element is in contact with the other element, but also when there is another element between the two elements.

Meanwhile, terms used in the following description, such as "up-and-down direction", "front-to-back direction", etc., are defined based on the drawings, and the shapes and positions of the respective elements are not limited by these terms. For example, the following terms "front" and "rear" may refer to an +X direction and a -X direction shown in the drawings, respectively. The following terms "up" and "down" may refer to a +Z direction and a -Z direction shown in the drawings, respectively. The following terms "left" and "right" may refer to a +Y direction and a -Y direction shown in the drawings, respectively. The following term "vertical direction" may refer to the Z direction shown in the drawings, and the following term "horizontal direction" may refer to the Y direction shown in the drawings. However, in some drawings, the +X direction may be referred to as "upward," and the -X direction may be referred to as "downward."

Hereinafter, various embodiments according to the present disclosure will be described in detail with reference to the accompanying drawings.

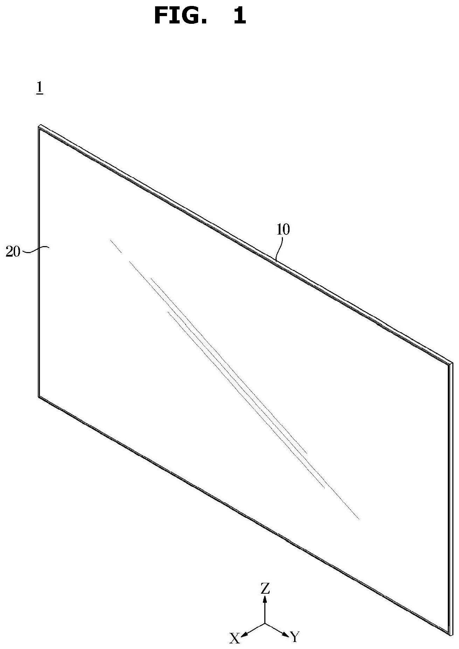

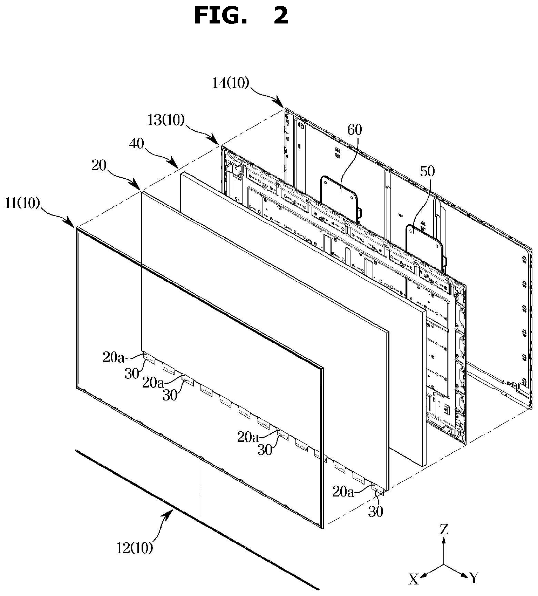

FIG. 1 is a perspective view illustrating a display apparatus according to an embodiment of the present disclosure. FIG. 2 is an exploded view illustrating the display apparatus according to an embodiment of the present disclosure.

Referring to FIGS. 1 and 2, a display apparatus 1 according to an embodiment of the present disclosure may be a device capable of processing an image signal received from an external source and visually displaying the processed image. The display apparatus 1 may be implemented in various forms, such as a television (TV), a monitor which is a kind of computer output device, a portable multimedia device, and a portable communication device. The display apparatus 1 is not limited to the forms shown in FIGS. 1 and 2 as long as it is a device that visually displays images.

Furthermore, the display apparatus 1 may be a large format display (LFD) that is installed outdoors, such as on the roof of a building or at a bus stop. Here, the outdoors is not necessarily limited to the open air, and the display apparatus 1 may be installed anywhere where a large number of people may come and go, even indoors, such as subway stations, shopping malls, movie theaters, companies, and stores.

The display apparatus 1 may be installed in a standing manner on an indoor or outdoor floor surface or furniture, or in a wall-mounted manner on or inside a wall.

While FIGS. 1 and 2 illustrate the display apparatus 1 as a flat display apparatus with a flat screen, it is not limited thereto and a display apparatus according to the concept of the present disclosure may also be applied to curved display apparatuses, or bendable or flexible display apparatuses that are capable of changing between flat and curved states. In addition, the configuration of the present disclosure may be applied to display apparatuses of various shapes, regardless of the screen size or ratio of the display apparatus.

The display apparatus 1 may receive content including video signals and audio signals from various content sources, and may output video and audio corresponding to the video signals and audio signals. For example, the display apparatus 1 may receive content data via a broadcast receiving antenna or a wired cable, receive content data from a content playback device, or receive content data from a content delivery server of a content provider.

The display apparatus 1 may display an image corresponding to video data and output sound corresponding to audio data. For example, the display apparatus 1 may restore a plurality of image frames included in the video data and display the plurality of image frames successively. Further, the display apparatus 1 may restore an audio signal included in the audio data and continuously output sound according to the audio signal.

The display apparatus 1 may include a display panel 20. The display panel 20 may be configured to display an image. The display panel 20 may form the front of the display apparatus 1 and may display the image forwardly. For example, the display panel 20 may display a still image or a moving image. For example, the display panel 20 may display a twodimensional (2D) planar image or a three-dimensional (3D) stereoscopic image using binocular parallax of a user.

The display panel 20 may include a plurality of pixels. The image displayed on the display panel 20 may be formed by light emitted from each of the plurality of pixels. For example, the light emitted by the plurality of pixels may be combined, such as in a mosaic, thereby forming an image on the screen.

Each of the plurality of pixels provided in the display panel 20 may emit light of various brightness and various colors. More specifically, each of the plurality of pixels may include sub-pixels, and the sub-pixels may include a red sub-pixel capable of emitting red light, a green sub-pixel capable of emitting green light, and a blue sub-pixel capable of emitting blue light. For example, the red light may represent light having a wavelength of approximately 620 nm (nanometer, 1 billionth of a meter) to 750 nm, the green light may represent light having a wavelength of approximately 495 nm to 570 nm, and the blue light may represent light having a wavelength of approximately 450 nm to 495 nm. Each of the plurality of pixels may emit light of various brightness and various colors by a combination of light emitted from the red sub-pixel, the green sub-pixel, and the blue sub-pixel, respectively.

In an example, the display panel 20 may be configured as a non-emissive display type panel, such as a liquid crystal display (LCD). Alternatively, the display panel 20 may be configured as a self-emissive display type panel, such as an organic light-emitting diode (OLED) or a micro-LED.

At one side of the display panel 20, a cable 20a that transmits image data to the display panel 20 and a display driver integrated circuit (DDI) 30 (hereinafter, referred to as a 'driver IC') that processes digital image data and outputs an analog image signal may be provided.

The cable 20a may electrically connect a source board 70, which will be described later, and the driver IC 30. In addition, the cable 20a may electrically connect the driver IC 30 and the display panel 20. The cable 20a may include a flexible flat cable, a film cable, or the like that may be bendable.

The driver IC 30 may receive image data and power from the source board 70 through the cable 20a, and may transmit image data and drive current to the display panel 20 via the cable 20a.

The cable 20a and the driver IC 30 may be integrally implemented as a film cable, a chip on film (COF), a tape carrier package (TCP), or the like. In other words, the driver IC 30 may be disposed on the cable 20b. However, the present disclosure is not limited thereto, and the driver IC 30 may be disposed on the display panel 20.

In an example, the cable 20a and the driver IC 30 may be disposed on a lower side of the display panel 20. The cable 20a may be connected to a lower portion of the display panel 20.

When the display apparatus 1 includes a non-emissive type display panel 20, the display apparatus 1 may include a backlight unit 40 configured to emit light toward the display panel 20. The backlight unit 40 may be disposed at a rear of the display panel 20 and configured to emit light toward the front where the display panel 20 is located. Specifically, the backlight unit 40 may be configured as a surface light source. The display panel 20 may block or allow light emitted from the backlight unit 40.

The backlight unit 40 may include a point light source that emits monochromatic light or white light, and may be configured to refract, reflect, and scatter light to convert light emitted from the point light source into uniform surface light. The backlight unit 40 may emit uniform surface light forwardly by refracting, reflecting, and scattering the light emitted from the point light source.

For example, the backlight unit 40 may include a light source module including a plurality of light sources configured to irradiate light and a light source substrate on which the plurality of light sources are mounted. In addition, the backlight unit 40 may include a reflective sheet configured to reflect light emitted from the light source module forward. Further, the backlight unit 40 may include a diffusion plate that uniformly diffuses light emitted from the light source module, and an optical sheet (a diffusion sheet, a prism sheet, a reflective polarization sheet, a quantum dot sheet, etc.) configured to refract and scatter light to improve luminance and uniformity of luminance of light.

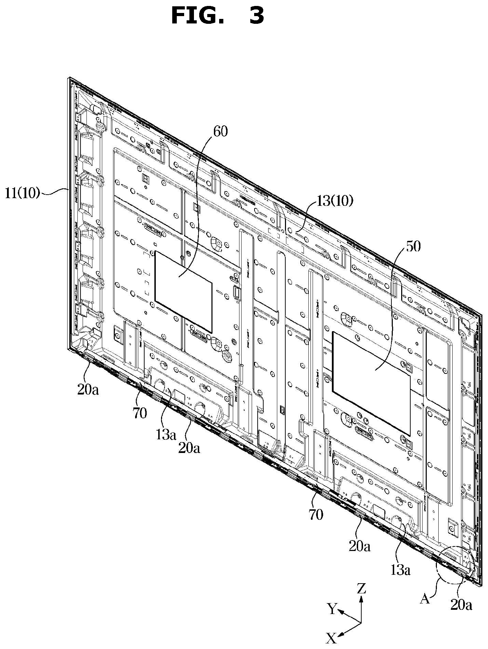

The display apparatus 1 may include various circuit boards 50, 60 and 70 (see FIG. 3). Electronic components may be mounted on the circuit boards 50, 60 and 70, and circuits including electronic components may be provided. For example, the circuits of the circuit boards 50, 60 and 70 may be formed by printing a conductive material such as copper (Cu) in a circuit line pattern on an electrically insulating substrate. The circuit boards 50, 60 and 70 may be configured to control various components to perform functions of the display apparatus 1, such as the display panel 20, the light source module of the backlight unit 40, and the like, and to supply power to the components.

For example, the display apparatus 1 may include various circuit boards, such as a main board 50, a power supply board 60, and a source board 70 (see FIG. 3).

The main board 50 may control the overall operation of the display apparatus 1. The main board 50 may include a processor and a power management device for driving the display apparatus 1. The main board 50 may include control circuitry for controlling components such as the display panel 20, the light source module of the backlight unit 40, a communication module of the display apparatus 1, and a content receiver for receiving content data from content sources. Electronic components constituting the control circuitry of the main board 50 may be mounted on one surface of the main board 50 facing in a direction opposite to the bottom chassis 13 (i.e., rearward).

The power supply board 60 may be configured to supply power to various components of the display apparatus 1. The power supply board 60 may include a switched mode power supply (SMPS) board. The power supply board 60 may include a power supply circuitry for supplying power to components such as the display panel 20, the light source module of the backlight unit 40, and the like. Electronic components constituting the control circuitry of the power supply board 60 may be mounted on one side of the power supply board 60 facing in the direction opposite to the bottom chassis 13 (i.e., rearward).

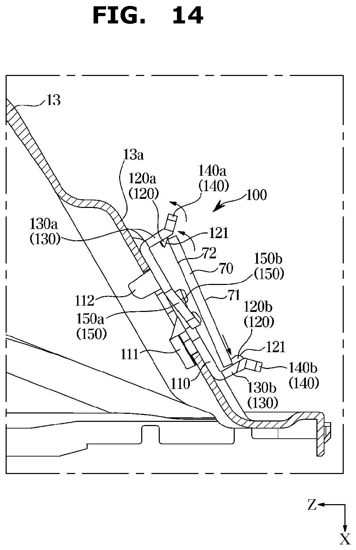

The source board 70 may control the display panel 20. The source board 70 may transmit drive signals to the display panel 20 via the cable 20a to control the display panel 20. The source board 70 may control the driver IC 30 to transmit drive signals to the display panel 20, thereby controlling the display panel 20. The source board 70 may include a control circuitry for controlling the display panel 20. Electronic components constituting the control circuitry of the source board 70 may be mounted on one side of the source board 70 facing in the direction opposite to the bottom chassis 13 (i.e., rearward) (a first surface 71 of the source board 70, see FIGS. 14 to 17, etc.).

The circuit boards, including the main board 50, the power supply board 60, and the source board 70, may be disposed independently of each other or arranged to be merged with each other. When the circuit boards are disposed independently of each other, the circuit boards may be electrically connected to each other to exchange data, signals, or power. That is, the main board 50, the power supply board 60, and the source board 70 may be electrically connected to each other. For example, the main board 50, the power supply board 60, and the source board 70 may be electrically connected to each other by cables to perform a function for driving the display apparatus 1. The cables may include various types of cables, such as a film cable, a flexible flat cable (FFC), and a flexible printed circuit board (FPCB).

The main board 50, the power supply board 60, and the source board 70 may each be supported by a display case 10, which will be described later. More specifically, the main board 50, the power supply board 60, and the source board 70 may each be mounted on the bottom chassis 13, which will be described later.

The display apparatus 1 may include the display case 10 that supports various components of the display apparatus 1. Various components of the display apparatus 1 may be accommodated inside the display case 10. The display case 10 may form an exterior of the display apparatus 1.

In an example, the display case 10 may support the display panel 20. In an example, the display case 10 may support the backlight unit 40. In an example, the display case 10 may support the circuit boards 50, 60 and 70.

The display case 10 may include a top chassis 11. The top chassis 13 may support a front to side of the display panel 20. In an example, the top chassis 11 may be provided in an approximately rectangular frame shape. As used herein, "front of the display panel 20" may refer to one face of the display panel 20 in the forward direction where the display panel 20 displays images. Also, as used herein, "side of the display panel 20" may refer to a border face of the display panel 20.

The top chassis 11 may support the front surface of the display panel 20 by forming a bezel disposed to face the front of the display apparatus 1. However, when the display apparatus 1 is a bezel-less type display apparatus with a very narrow or no bezel, the top chassis 11 may be configured to support simply the side surfaces of the display panel 20. Alternatively, when the bottom chassis 13 supports the side surfaces of the display panel 20, the display case 10 may not include the top chassis 11.

The display case 10 may include a front cover 12 that covers the cables 20a. More specifically, the bezel-less type display apparatus 1 may include the front cover 12 to prevent the cables 20a from being exposed to the outside.

The front cover 12 may be coupled to the top chassis 11. In an example, the front cover 12 may be coupled to a lower portion of the top chassis 11 to cover the cables 20a.

The front cover 12 may have the shape of a bar extending in approximately one direction. In an example, the front cover 12 may have a bar shape extending in a left-to-right direction (Y).

Alternatively, however, the display case 10 may not include the front cover 12 configured separately from the top chassis 11, and in this case, the cables 20a may be covered by the top chassis 11.

The display case 10 may include the bottom chassis 13. The bottom chassis 13 may cover the rear of the display panel 20. The bottom chassis 13 may be coupled to the rear of the top chassis 11. The bottom chassis 13 may support various components of the display apparatus 1, such as the backlight unit 40, the main board 50, the power supply board 60, and the source board 70.

The backlight unit 40 may be disposed in front of the bottom chassis 13. The backlight unit 40 may be mounted on a front surface of the bottom chassis 13. As used herein, the "front surface of the bottom chassis 13" may refer to one face of the bottom chassis 13 in the forward direction facing the display panel 20.

The main board 50, the power supply board 60, and the source board 70 may each be disposed at the rear of the bottom chassis 13. The main board 50, the power supply board 60, and the source board 70 may each be mounted on a rear surface of the bottom chassis 13. As used herein, the "rear surface of the bottom chassis 13" may refer to one face of the bottom chassis 13 in a rearward direction opposite to the display panel 20.

The bottom chassis 13 may be formed to have an approximately flat plate shape, but is not limited thereto.

The bottom chassis 13 may include a material having a high thermal conductivity so as to dissipate heat generated from the backlight unit 40 to the outside. In an example, the bottom chassis 13 may include a metal material such as aluminum, SUS, or the like, or a plastic material such as ABS.

The display case 10 may include a rear cover 14. The rear cover 14 may be disposed at the rear of the bottom chassis 13. The rear cover 14 may be coupled to the rear of the bottom chassis 13. The rear cover 14 may cover various components (e.g., the main board 50, the power supply board 60, the source board 70, and the like) mounted on the rear side of the bottom chassis 13.

The configuration of the display apparatus 1 described above with reference to FIGS. 1 and 2 is merely an example of the present disclosure, and the ideas of the present disclosure is not limited thereto. The display apparatus 1 may include various configurations to perform the function of providing an image.

For example, unlike what is shown in FIGS. 1 and 2, the display apparatus 1 may include a self-emissive display panel and may not include a backlight unit emitting light toward the display panel.

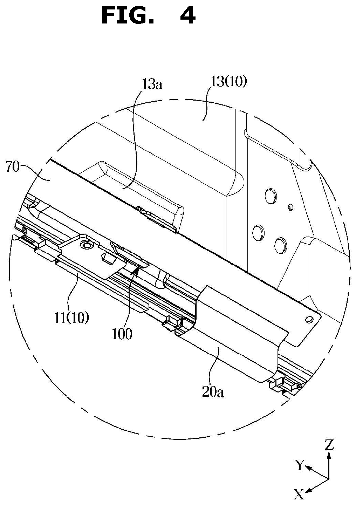

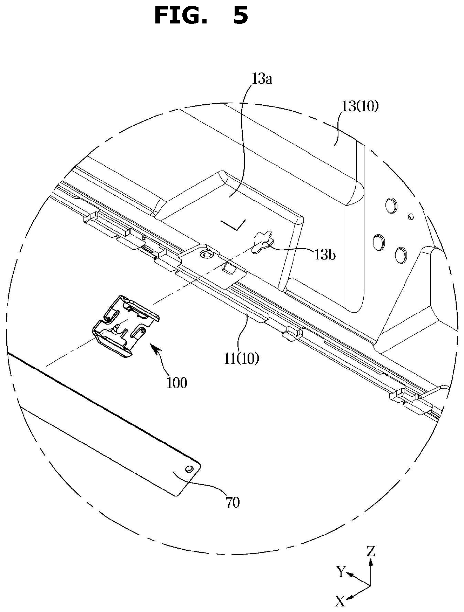

FIG. 3 is a view illustrating some configurations, such as a bottom chassis and a source board, of the display apparatus according to an embodiment of the present disclosure from the rear. FIG. 4 is an enlarged view illustrating portion A of FIG. 3. FIG. 5 is an exploded view of the bottom chassis, the board holder, and the source board shown in FIG. 4.

Referring to FIGS. 3 to 5, in the display apparatus 1 according to an embodiment of the present disclosure, the circuit boards 50, 60 and 70 may be supported by the bottom chassis 13. The circuit boards 50, 60 and 70 may be mounted to the bottom chassis 13. The circuit boards 50, 60 and 70 may be mounted on the rear surface of the bottom chassis 13.

For example, the main board 50 may be mounted in a region inward from an edge portion 13a at the rear surface of the bottom chassis 13. As shown in FIG. 3, the main board 50 may be disposed in a region biased to one side away from a center portion of the bottom chassis 13. Alternatively, the main board 50 may be disposed in a region adjacent to the center portion of the bottom chassis 13.

The main board 50 may be secured to the bottom chassis 13 by various fastening structures, such as retaining clips, hook structures, screws, and the like.

For example, the power supply board 60 may be mounted in a region inward of the edge portion 13a of the rear surface of the bottom chassis 13. As shown in FIG. 3, the power supply board 60 may be disposed in a region biased to one side away from the center portion of the bottom chassis 13. In this case, as shown in FIG. 3, the main board 50 and the power supply board 60 may be disposed to be biased toward opposite sides from the center portion of the bottom chassis 13.

In FIG. 3, the main board 50 is shown as being positioned on the left side and the power supply board 60 is positioned on the right side, but the positions of the main board 50 and the power supply board 60 are not limited thereto. Alternatively, the main board 50 and the power supply board 60 may be disposed to be biased to each other from the center portion of the bottom chassis 13 in the same direction.

Alternatively, the power supply board 60 may be disposed in a region adjacent to the center portion of the bottom chassis 13.

The power supply board 60 may be secured to the bottom chassis 13 by various fastening structures, such as retaining clips, hook structures, screws, and the like.

For example, the source board 70 may be mounted to the edge portion 13a of the rear surface of the bottom chassis 13. The edge portion 13a may include an area extending inwardly from an outline in a range adjacent to the outline of the bottom chassis 13. In other words, the source board 70 may be disposed adjacent to the edge of the rear surface of the bottom chassis 13. By mounting the source board 70 to the edge portion 13a of the bottom chassis 13, a distance between the source board 70 and the edge of the display panel 20 may be reduced, and a length of the cable 20a connecting the source board 70 and the edge of the display panel 20 may be shortened.

More specifically, as shown in FIG. 3, the source board 70 may be disposed adjacent to a lower edge of the bottom chassis 13. The source board 70 may be disposed along the lower edge of the bottom chassis 13. The source board 70 may extend along the lower edge of the bottom chassis 13.

However, alternatively, the source board 70 may be disposed at various positions on the edge portion 13a of the rear surface of the bottom chassis 13. The source board 70 may be disposed along a long-side one of the edges of the bottom chassis 13, or may be disposed along a short-side one. The source board 70 may be disposed along an upper edge of the bottom chassis 13. The source board 70 may be disposed along a left edge or a right edge of the bottom chassis 13.

In an example, the source board 70 may be provided in a plurality of two, three, or more. The plurality of source boards 70 may be electrically connected to each other. The plurality of source boards 70 may be arranged side by side with each other on the edge portion 13a of the bottom chassis 13. In an example, as shown in FIG. 3, the plurality of source boards 70 may be arranged side by side along the lower edge of the bottom chassis 13. However, the number of source boards 70 may vary depending on the size of the display panel 20, and the display apparatus 1 may include only one integrated source board 70.

As shown in FIGS. 3 to 5, the edge portion 13a on the rear surface of the bottom chassis 13 may extend in an inclined direction relative to an extension direction of the display panel 20. For example, the edge portion 13a may be formed to be inclined such that the edge portion extends forward toward an edge direction. Alternatively, the edge portion 13a may be disposed in line with the display panel 20.

The display apparatus 1 may include a board holder 100 that secures the source board 70 to the bottom chassis 13. The board holder 100 may mount the source board 70 to the bottom chassis 13. The source board 70 may be mounted to the board holder 100 and supported by the bottom chassis 13. The source board 70 may be mounted to the board holder 100 and secured to the bottom chassis 13.

The board holder 100 may be disposed on the rear surface of the bottom chassis 13. The board holder 100 may be disposed on the rear surface of the bottom chassis 13 to mount the source board 70 to the rear surface of the bottom chassis 13. Specifically, the board holder 100 may be disposed on the edge portion 13a of the rear surface of the bottom chassis 13. In an example, the board holder 100 may be disposed adjacent to the lower edge of the bottom chassis 13.

The board holder 100 may be secured to the bottom chassis 13. The board holder 100 may be coupled to the bottom chassis 13. The board holder 100 may be coupled to the rear surface of the bottom chassis 13. The board holder 100 may be coupled to the edge portion 13a of the rear surface of the bottom chassis 13. The position where the board holder 100 is coupled to the bottom chassis 13 may vary depending on the designed position of the source board 70.

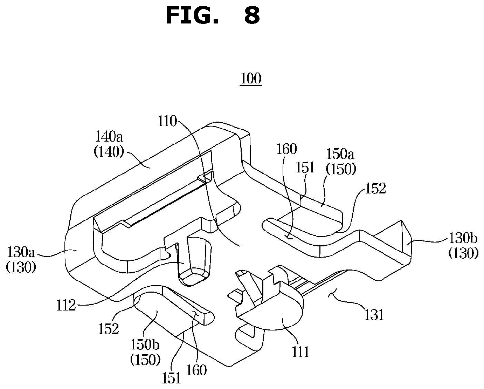

For example, the bottom chassis 13 may include a coupling hole 13b formed such that the board holder 100 is coupled thereto, and the bottom chassis 13 may include chassis coupling portions 111 and 112 (see FIG. 8) penetrating the coupling hole 13b to be coupled to the bottom chassis 13. In an example, the coupling hole 13b may be provided in the edge portion 13a of the bottom chassis 13.

Alternatively, the board holder 100 may be secured to the bottom chassis 13 by various structures, such as being fastened to the bottom chassis 13 by screws. Alternatively, the board holder 100 may be formed integrally with the bottom chassis 13. Hereinafter, it is assumed that the board holder 100 is formed as a separate part from the bottom chassis 13 and has a structure that is coupled to the coupling hole 13b of the bottom chassis 13, and a detailed description of the structure that enables the board holder 100 to be coupled to the coupling hole 13b will be described later.

The display apparatus 1 may include a plurality of board holders 100. The plurality of board holders 100 may each hold the plurality of source boards 70 to the bottom chassis 13. Alternatively, the plurality of board holders 100 may hold only one source board 70 to the bottom chassis 13. The number of board holders 100 may vary depending on the size of the display panel 20, the length, the number of the source boards 70, and the like.

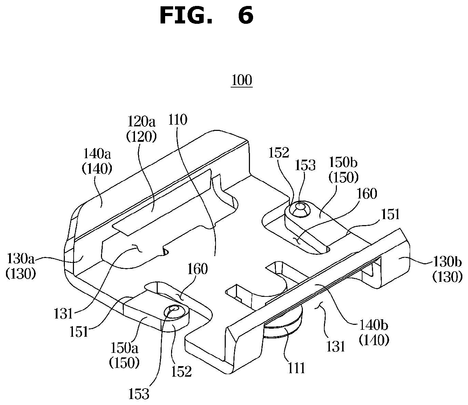

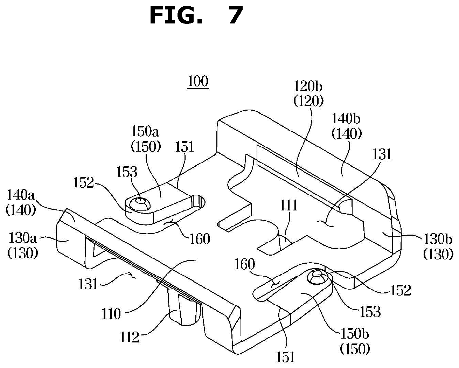

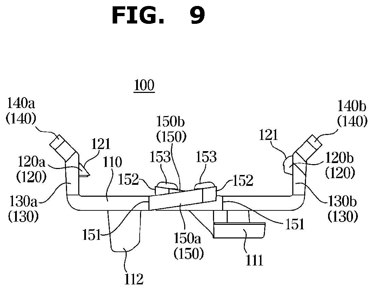

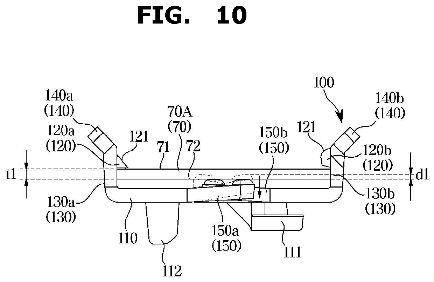

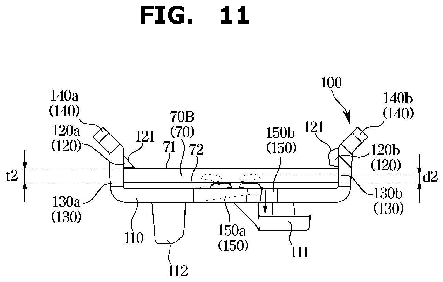

FIG. 6 is a perspective view illustrating a board holder included in the display apparatus according to an embodiment of the present disclosure, viewed from one direction. FIG. 7 is a perspective view illustrating the board holder included in the display apparatus according to an embodiment of the present disclosure, viewed from another direction. FIG. 8 is a perspective view illustrating the board holder included in the display apparatus according to an embodiment of the present disclosure, viewed from another direction. FIG. 9 is a view illustrating a state before the source board is mounted to the board holder included in the display apparatus according to an embodiment of the present disclosure. FIG. 10 is a view illustrating a state where a source board of a first thickness is mounted to the board holder included in the display apparatus according to an embodiment of the present disclosure. FIG. 11 is a view illustrating a state where a source board of a second thickness is mounted to the board holder included in the display apparatus according to an embodiment of the present disclosure.

Referring to FIGS. 6 to 11, the board holder 100 of the display apparatus 1 according to an embodiment of the present disclosure may include a holder body 110. The holder body 110 may be secured to the bottom chassis 13. The holder body 110 may be mounted to the bottom chassis 13. The holder body 110 may be supported by the bottom chassis 13.

The holder body 110 may be in contact with the rear surface of the bottom chassis 13. The holder body 110 may be in contact with the edge portion 13a of the bottom chassis 13. One surface of the holder body 110 on the side opposite to the source board 70 may be in contact with the rear surface of the bottom chassis 13.

When the source board 70 is mounted to the board holder 100, the source board 70 may be positioned on a side opposite to the bottom chassis 13 relative to the holder body 110.

The holder body 110 may be coupled to the rear surface of the bottom chassis 13. Specifically, the holder body 110 may be coupled to the edge portion 13a of the rear surface of the bottom chassis 13. The holder body 110 may be coupled to the rear surface of the bottom chassis 13 and secured to the bottom chassis 13. The holder body 110 may be coupled to the rear surface of the bottom chassis 13 and supported by the bottom chassis 13. By the holder body 110 being supported by the bottom chassis 13, the source board 70 mounted on the board holder 100 may also be supported by the bottom chassis 13.

The holder body 110 may be coupled to the coupling hole 13b in a shape formed by the edge portion 13a of the bottom chassis 13 being penetrated. The holder body 110 may include the chassis coupling portions 111 and 112 configured to be coupled to the coupling hole 13b.

For example, the holder body 110 may include a first chassis coupling portion 111 catch-coupled to the coupling hole 13b. The first chassis coupling portion 111 may pass through the coupling hole 13b and extend from the front of the coupling hole 13b to the outside of an edge of the coupling hole 13b, so as to be catch-coupled to the coupling hole 13b. In other words, the first chassis coupling portion 111 may contact the front surface of the bottom chassis 13 and be catch-coupled to the coupling hole 13b. By the first chassis coupling portion 111, the board holder 100 may be restrained from moving in a direction orthogonal to the edge portion 13a. Here, the "direction orthogonal to the edge portion 13a" may refer to a direction approximately aligned with a normal direction of the edge portion 13a, or a direction approximately aligned with a direction in which the coupling hole 13b penetrates.

The holder body 110 may also include a second chassis coupling portion 112. The second chassis coupling portion 112 may penetrate the coupling hole 13b. When the board holder 100 is coupled to the bottom chassis 13, the first chassis coupling portion 111 may be positioned on one side of the edge of the coupling hole 13b, and the second chassis coupling portion 112 may be positioned on the other side of the edge of the coupling hole 13b. Thus, the board holder 100 may be restrained by the first chassis coupling portion 111 and the second chassis coupling portion 112 from moving in a direction parallel to the edge portion 13a. Here, the "direction parallel to the edge portion 13a" may refer to any straight line direction on a plane parallel to the edge portion 13a, or a direction approximately orthogonal to the normal direction of the edge portion 13a.

In an example, a portion of the first chassis coupling portion 111 may have a structure extending from a front of the coupling hole 13b in a direction away from the second chassis coupling portion 112, so as to be catch-coupled to the coupling hole 13b.

In an example, the second chassis coupling portion 112 may extend in a direction approximately orthogonal to the edge portion 13a.

In an example, the second chassis coupling portion 112 may be spaced apart from the first chassis coupling portion 111.

The board holder 100 may include a catch portion 120 configured to support the source board 70. Specifically, the catch portion 120 may support one surface of the source board 70 opposite to the bottom chassis 13. The catch portion 120 may contact the one surface of the source board 70 opposite to the bottom chassis 13 to support the one surface of the source board 70. The catch portion 120 may be configured such that the one surface of the source board 70 opposite to the bottom chassis 13 is caught, thereby preventing the source board 70 from being dislodged from the board holder 100. Hereinafter, the one surface of the source board 70 opposite to the bottom chassis 13 may be referred to as a first surface 71 of the source board 70. The catch portion 120 may be positioned on a side opposite to the bottom chassis 13 with respect to the holder body 110, so as to support the first surface 71 of the source board 70. The first surface 71 of the source board 70 may be defined as one surface of the source board 70 opposite to the holder body 110.

The catch portion 120 may be named with a term such as a "hook 120".

The catch portion 120 may be connected to the holder body 110. Specifically, the board holder 100 may include a connection portion 130 connecting the holder body 110 and the catch portion 120. The connection portion 130 may extend from the holder body 110 in a direction away from the bottom chassis 13. The catch portion 120 may protrude from the connection portion 130.

The source board 70 mounted on the board holder 100 may be disposed in an inward direction relative to the connection portion 130. The "Inward direction" or "outward direction" may be defined relative to the board holder 100, and a position where the source board 70 mounted on the board holder 100 is disposed may be defined as an inner side of the board holder 100. Since the source board 70 is positioned in the inward direction relative to the connection portion 130, the catch portion 120 may protrude inwardly from the connection portion 130 to support the first surface 71 of the source board 70.

The catch portion 120 may be provided in a plurality. For example, the catch portion 120 may include a first catch portion 120a and a second catch portion 120b. The first catch portion 120a and the second catch portion 120b may be disposed to face each other. The first catch portion 120a and the second catch portion 120b may be disposed to be spaced apart from each other. The first catch portion 120a and the second catch portion 120b may each contact the first surface 71 of the source board 70 and support the first surface 71 of the source board 70. The first catch portion 120a and the second catch portion 120b may each support the first surface 71 of the source board 70 from opposite sides thereof. As such, by providing the plurality of catch portions 120, the source board 70 may be more firmly supported on the catch portions 120.

Corresponding to the number of catch portions 120, the connection portion 130 may be provided in a plurality. For example, the connection portion 130 may include a first connection portion 130a connecting the first catch portion 120a and the holder body 110, and a second connection portion 130b connecting the second catch portion 120b and the holder body 110.

The first connection portion 130a and the second connection portion 130b may be disposed to face each other. The first connection portion 130a and the second connection portion 130b may be arranged in parallel to each other. The first connection portion 130a and the second connection portion 130b may extend from the holder body 110 in a direction parallel to each other. The first connection portion 130a and the second connection portion 130b may be disposed to be spaced apart from each other.

The first catch portion 120a may protrude from the first connection portion 130a. The first catch portion 120a may protrude inwardly from the first connection portion 130a. The second catch portion 120b may protrude from the second connection portion 130b. The second catch portion 120b may protrude inwardly from the second connection portion 130b. The first catch portion 120a and the second catch portion 120b may protrude from the first connection portion 130a and the second connection portion 130b, respectively, in a direction facing each other.

The board holder 100 may include a pressing portion 150 configured to support the source board 70. Specifically, the pressing portion 150 may support the other surface of the source board 70 facing the bottom chassis 13. The pressing portion 150 may contact the other surface of the source board 70 facing the bottom chassis 13 to support the other surface of the source board 70. Hereinafter, the other surface of the source board 70 facing the bottom chassis 13 may be referred to as a second surface 72. The second surface 72 of the source board 70 may be defined as one surface of the source board 70 adjacent to the holder body 110.

When the source board 70 is mounted to the board holder 100, the first surface 71 of the source board 70 may be in contact with the catch portion 120, and the second surface 72 of the source board 70 may be in contact with the pressing portion 150. In other words, the first surface 71 of the source board 70 may be supported by the catch portion 120, and the second surface 72 may be supported by the pressing portion 150. Thus, when the source board 70 is mounted to the board holder 100, a distance between the catch portion 120 and the pressing portion 150 may correspond to a thickness of the source board 70. The thickness of the source board 70 may be defined as a distance between the first surface 71 and the second surface 72.

On the other hand, the thickness of the source board 70 may be designed to vary. However, if the distance between the catch portion 120 and the pressing portion 150 is always kept constant, source boards 70 of various thicknesses may not be able to be mounted on the board holder 100. Thus, depending on how the thickness of the source board 70 is designed, it may be necessary to design the shape of the board holder 100 differently, which may increase design costs of components such as the board holder 100 and reduce the efficiency of the manufacturing process. Also, if the distance between the catch portion 120 and the pressing portion 150 does not correspond to the thickness of the source board 70, the board holder 100 may not be able to securely hold the source board 70.

To address such an issue, the pressing portion 150 may be configured to press the second surface 72 of the source board 70 toward the catch portion 120. In other words, the pressing portion 150 may be configured to press the second surface 72 of the source board 70 in a direction away from the bottom chassis 13.

The pressing portion 150 may be movably arranged relative to the holder body 110. The pressing portion 150 may be movably supported on the holder body 110. The pressing portion 150 may be movably arranged relative to the holder body 110 to press the second surface 72 of the source board 70 toward the catch portion 120. The pressing portion 150 may be configured to be elastically deformed when an external force is applied. The pressing portion 150 may move relative to the holder body 110 as an external force is applied to the pressing portion 150 to elastically deform the pressing portion 150. The pressing portion 150 may be connected to the holder body 110 and may be configured to be movable relative to the holder body 110 when elastically deformed.

The pressing portion 150 may include an elastic material that is elastically deformable when an external force is applied. For example, the pressing portion 150 may include a variety of materials having elasticity, such as a plastic material.

The pressing portion 150 may include a fixed end 151 connected to the holder body 110 and a free end 152 movable relative to the holder body 110. The free end 152 may be opposite to the fixed end 151. The fixed end 151 may be one end of the pressing portion 150 connected to the holder body 110 and fixed relative to the holder body 110, and the free end 152 may be the other end of the pressing portion 150 opposite to the fixed end 151, disconnected from the holder body 110, and movable relative to the holder body 110. The pressing portion 150 may extend from the fixed end 151 to the free end 152.

In an example, the board holder 100 may include a gap 160 formed between the free end 152 and the holder body 110. The gap 160 may be formed in a shape in which a portion between the free end 152 and the holder body 110 is cut out. The gap 160 may allow the pressing portion 150 to be connected to the holder body 110 at the fixed end 151, but spaced apart from the holder body 110 at the free end 152, so that the free end 152 may be movable relative to the holder body 110. Thus, the free end 152 may move relative to the holder body 110 when an external force is applied, and the pressing portion 150 may be elastically deformed by the external force.

The second surface 72 of the source board 70 may be pressed by the free end 152. By being configured to be movable relative to the holder body 110, the free end 152 may press against the second surface 72 of the source board 70. As a reaction to such, the free end 152 may be pressed by the second surface 72 of the source board 70 when the source board 70 is mounted to the board holder 100, thereby causing the pressing portion 150 to be elastically deformed such that the free end 152 moves in a direction closer to the bottom chassis 13.

The pressing portion 150 may further include a support protrusion 153 provided on the free end 152 and protruding toward the source board 70 to support the source board 70. The support protrusion 153 may press against the second surface 72 of the source board 70 as the free end 152 moves. In addition, as the support protrusion 153 is pressed by the source board 70, the pressing portion 150 may be elastically deformed. With such a configuration, the pressing portion 150 may more efficiently press and support the source board 70.

In an example, the support protrusion 153 may be formed in a convex curved shape or an approximately dome shape.

The pressing portion 150 may extend from the fixed end 151 to the free end 152 in a direction away from the bottom chassis 13. The pressing portion 150 may extend to be inclined such that the pressing portion 150 is inclined away from the bottom chassis 13 as it extends from the fixed end 151 toward the free end 152. In other words, the pressing portion 150 may extend in a direction approaching the catch portion 120 from the fixed end 151 to the free end 152. An extension direction of the pressing portion 150 from the fixed end 151 to the free end 152 may be inclined with respect to the holder body 110. Even in this case, in an example, a distance between the free end 152 and the bottom chassis 13 may be shorter than a distance between the catch portion 120 and the bottom chassis 13. When no source board 70 is mounted on the board holder 100, an inclination angle of the pressing portion 150 relative to the bottom chassis 13 or the holder body 110 may be the largest, and the inclination angle of the pressing portion 150 may gradually decrease as the thickness of the source board 70 mounted on the board holder 100 increases.

Referring to FIGS. 9 to 11, the relative position of the pressing portion 150 with respect to the holder body 110 may vary depending on the thickness of the source board 70 mounted on the board holder 100. For example, as shown in FIG. 11, a distance d2 moved by the free end 152 being pressed by a source board 70B when the source board 70B having a second thickness t2 greater than a first thickness t1 is mounted to the board holder 100 may be longer than a distance d1 moved by the free end 152 being pressed by a source board 70A having the first thickness t1 when the source board 70A is mounted to the board holder 100, as shown in FIG. 10. That is, depending on the thickness of the source board 70, the relative position of the pressing portion 150 with respect to the holder body 110 may vary, and the distance between the catch portion 120 and the pressing portion 150 may vary.

In an example, the extension direction of the pressing portion 150 from the fixed end 151 to the free end 152 when the pressing portion 150 is maximally elastically deformed may be substantially parallel to the holder body 110 and the bottom chassis 13 (see FIG. 11).

As such, as the pressing portion 150 is configured to be movable relative to the holder body 110 and to press the source board 70 toward the catch portion 120, the distance between the catch portion 120 and the pressing portion 150 may be variable in response to the thickness of the source board 70. Thus, the board holder 100 may hold source boards 70 of various thicknesses to the bottom chassis 13. Since it is possible to hold the source boards 70 of various thicknesses to the bottom chassis 13 with only a single type of board holder 100 designed, production costs, such as mold manufacturing costs for the product, may be reduced. Furthermore, by using such a board holder 100, the source board 70 may be more firmly held to the bottom chassis 13.

In an example, the board holder 100 may be configured to allow the source board 70 having a thickness of approximately 0.6 mm or more and 1.2 mm or less to be mounted. In an example, the board holder 100 may be configured such that the distance between the catch portion 120 and the support protrusion 153 of the pressing portion 150 varies in a range of approximately 0.45 mm or more and 1.5 mm or less as the pressing portion 150 is elastically deformed.

The pressing portion 150 may be provided in a plurality. For example, the pressing portion 150 may include a first pressing portion 150a and a second pressing portion 150b. The first pressing portion 150a and the second pressing portion 150b may each contact the second surface 72 of the source board 70 to support the second surface 72 of the source board 70. The first pressing portion 150a and the second pressing portion 150b may each press against the second surface 72 of the source board 70. The first pressing portion 150a and the second pressing portion 150b may press the second surface 72 of the source board 70 toward the first catch portion 120a and the second catch portion 120b, respectively. The first pressing portion 150a and the second pressing portion 150b may face each other and may have a shape symmetrical to each other.

The first pressing portion 150a and the second pressing portion 150b may each be connected to the holder body 110. The first pressing portion 150a and the second pressing portion 150b may each be movably supported on the holder body 110.

The first pressing portion 150a and the second pressing portion 150b may be disposed spaced apart from each other. In an example, the first pressing portion 150a may be connected to one side of the edge of the holder body 110, and the second pressing portion 150b may be connected to the other side of the edge of the holder body 110.

The first pressing portion 150a and the second pressing portion 150b may be disposed to face each other. The direction in which the first catch portion 120a and the second catch portion 120b face each other may be different from the direction in which the first pressing portion 150a and the second pressing portion 150b face each other. For example, assuming that the first catch portion 120a and the second catch portion 120b face each other in a first direction, the first pressing portion 150a and the second pressing portion 150b may face each other in a second direction orthogonal to the first direction. Alternatively, however, the first direction in which the first catch portion 120a and the second catch portion 120b face each other and the second direction in which the first pressing portion 150a and the second pressing portion 150b face each other may be different from each other but not orthogonal to each other. Alternatively, the first direction and the second direction may be parallel to each other.

The first pressing portion 150a may extend from the first fixed end 151 connected to the holder body 110, to the first free end 152 opposite to the first fixed end 151 and movable relative to the holder body 110. Similarly, the second pressing portion 150b may extend from the second fixed end 151 connected to the holder body 110 to the second free end 152 opposite to the second fixed end 151 and movable relative to the holder body 110.

The first pressing portion 150a and the second pressing portion 150b may be formed opposite to each other. Specifically, the direction in which the first pressing portion 150a extends from the first fixed end 151 to the first free end 152 may be opposite to the direction in which the second pressing portion 150b extends from the first fixed end 151 to the first free end 152.

The first fixed end 151 of the first pressing portion 150a may be more adjacent to the first catch portion 120a of the first catch portion 120a and the second catch portion 120b, and the second fixed end 151 of the second pressing portion 150b may be more adjacent to the second catch portion 120b of the first catch portion 120a and the second catch portion 120b.

In addition, the first free end 152 of the first pressing portion 150a may be more adjacent to the second catch portion 120b of the first catch portion 120a and the second catch portion 120b, and the second free end 152 of the second pressing portion 150b may be more adjacent to the first catch portion 120a of the first catch portion 120a and the second catch portion 120b.

In this case, the first free end 152 of the first pressing portion 150a may press the source board 70 in a direction more biased toward the second catch portion 120b of the first catch portion 120a and the second catch portion 120b. In addition, the second free end 152 of the second pressing portion 150b may press the source board 70 in a direction more biased toward the first catch portion 120a of the first catch portion 120a and the second catch portion 120b.

By such a structure including the first pressing portion 150a and the second pressing portion 150b, the source board 70 may be more efficiently pressed and supported by the first pressing portion 150a and the second pressing portion 150b. Furthermore, the source board 70 may be better balanced inside the board holder 100 by the first pressing portion 150a and the second pressing portion 150b.

However, unlike described above, the first fixed end 151 and the first free end 152 of the first pressing portion 150a may each be more adjacent to the first catch portion 120a of the first catch portion 120a and the second catch portion 120b. In addition, the second fixed end 151 and the second free end 152 of the second pressing portion 150b may each be more adjacent to the second catch portion 120b of the first catch portion 120a and the second catch portion 120b.

As such, by including the catch portion 120 and the pressing portion 150, the board holder 100 may be configured to accommodate source boards 70 of various thicknesses. On the other hand, a space in which the source board 70 is positioned within the board holder 100 may be formed between the catch portion 120 and the pressing portion 150. The space in which the source board 70 is positioned within the board holder 100 may be open on a side opposite to the bottom chassis 13, but some areas may be blocked by the catch portion 120. Thus, in the process of mounting the source board 70 to the board holder 100, a portion of the source board 70 may be interfered with by the catch portion 120 when attempting to insert the source board 70 into the board holder 100 in a direction approximately perpendicular to the bottom chassis 13. In other words, the process of mounting the source board 70 to the board holder 100 may not be easy.

Furthermore, in a state where the source board 70 is mounted on the board holder 100, the first surface 71 of the source board 70 may be in contact with the catch portion 120 and the second surface 72 may be in contact with the pressing portion 150, so that the source board 70 may be restrained from the inner side of the board holder 100. Thus, it may not be easy to remove the source board 70 from the board holder 100 for reasons such as repair, inspection, or replacement of the source board 70.

To address such an issue, the catch portion 120 may be movably arranged relative to the holder body 110. Specifically, the catch portion 120 may be configured to be movable relative to the holder body 110 when an external force is applied to the catch portion 120. The catch portion 120 may be movably supported on the holder body 110 when an external force is applied to the catch portion 120.

The catch portion 120 may be configured to be movable relative to the holder body 110 by elastic deformation when an external force is applied. The connection portion 130 may be configured to be elastically deformable when an external force is applied to the catch portion 120, and as the connection portion 130 is elastically deformed, the catch portion 120 may move relative to the holder body 110.

Specifically, the connection portion 130 may be configured to bend outwardly when an external force is applied to the catch portion 120 in a direction toward the holder body 110. In other words, the connection portion 130 may be configured to bend in an outward direction when an external force is applied to the catch portion 120 in a direction toward the bottom chassis 13. As described above, the space where the source board 70 is positioned within the board holder 100 may be formed in an inward direction with respect to the connection portion 130, and the catch portion 120 may protrude inwardly from the connection portion 130, so that when the connection portion 130 is bent outwardly, the catch portion 120 may move outwardly to allow the internal space of the board holder 100 to be more widely opened.

The first connection portion 130a may be configured to be elastically deformed when an external force is applied to the first catch portion 120a. The first connection portion 130a may be configured to be elastically deformed such that the first catch portion 120a moves in a direction away from the second catch portion 120b when an external force in a direction toward the holder body 110 (or the bottom chassis 13) is applied to the first catch portion 120a. With such a structure, the first catch portion 120a may move in a direction away from the second catch portion 120b when pressed in the direction toward the holder body 110 (or the bottom chassis 13).

The second connection portion 130b may be configured to be elastically deformed when an external force is applied to the second catch portion 120b. The second connection portion 130b may be configured to be elastically deformed such that the second catch portion 120b moves in a direction away from the first catch portion 120a when an external force in a direction toward the holder body 110 (or the bottom chassis 13) is applied to the second catch portion 120b. With such a structure, the second catch portion 120b may move in a direction away from the first catch portion 120a when pressed in the direction toward the holder body 110 (or the bottom chassis 13).

As such, the first connection portion 130a and the second connection portion 130b may be bent outwardly when the first catch portion 120a and the second catch portion 120b are pressed in a direction toward the holder body 110 (or the bottom chassis 13), respectively, and the first catch portion 120a and the second catch portion 120b may move in a direction away from each other to allow the internal space of the board holder 100 to be more widely opened.

The connection portion 130 may include an elastic material to allow for elastic deformation when an external force is applied. For example, the connection portion 130 may include various materials having elasticity, such as a plastic material.

A connection portion hole 131 may be formed in a portion of the board holder 100 in which the connection portion 130 of the board holder 100 and the holder body 110 are connected. The connection portion hole 131 may be formed at a portion thereof where one end of each of the first connection portion 130a and the second connection portion 130b that is connected to the holder body 110. The connection portion hole 131 may be formed in a shape such that a portion of one end of the connection portion 130 adjacent to the holder body 110 of the connection portion 130 is penetrating. With the connection portion hole 131 formed, the connection portion 130 may be more efficiently elastically deformable. In addition, the formation of the connection portion hole 131 may facilitate the separation of the injectionmolded product from an injection mold in which a portion corresponding to the catch portion 120 and the connection portion 130 is formed, which may improve efficiency in the manufacturing process.

The catch portion 120 may include an inclined surface 121. The inclined surface 121 may be provided on one surface of the catch portion 120 facing the outer side of the board holder 100. In a state where the source board 70 is mounted on the board holder 100, the inclined surface 121 may be positioned opposite to the first surface 71 of the source board 70. Accordingly, when the source board 70 is inserted into the board holder 100, the inclined surface 121 may be pressed by the source board 70.

The catch portion 120 may include the inclined surface 121 extending to face inwardly as it approaches the holder body 110. In other words, the inclined surface 121 may extend to face inwardly as it approaches the bottom chassis 13. The inclined surface 121 may extend such that a length of the inclined surface 121 protruding from the connection portion 130 increases as it approaches the holder body 110 (or the bottom chassis 13).

With such a structure, the inclined surface 121 may guide the source board 70 to enter the interior of the board holder 100. Further, by such a structure, as the source board 70 enters further into the interior of the board holder 100, the degree to which it is pressed by the source board 70 may increase, thereby increasing the degree to which the connection portion 130 is bent outwardly, and the source board 70 may easily enter the interior of the board holder 100.

In an example, like the inclined surface 121 of the first catch portion 120a, the inclined surface 121 may have the shape of a flat surface extending in one direction. Alternatively, in an example, like the inclined surface 121 of the second catch portion 120b, the inclined surface 121 may have the shape of a curved surface. In particular, like the inclined surface 121 of the second catch portion 120b, the inclined surface 121 may have the shape of a convex curved surface.

However, the shape of the catch portion 120 is not limited to those described above.

With such a structure, the source board 70 may be easily mounted within the board holder 100 by allowing the space inside the board holder 100 to be more widely opened by pressing the source board 70 against the catch portion 120 during the process of mounting the source board 70 to the board holder 100. Further, by such a structure, it may be possible to mount the source board 70 on the board holder 100 by entering the source board 70 into the board holder 100 in a direction approximately perpendicular to the bottom chassis 13.

Thus, utilizing such a structure of the board holder 100, the process of mounting the source board 70 on the bottom chassis 13 may be performed efficiently and easily. Accordingly, it is possible to shorten the manufacturing time of the product and reduce the manufacturing cost. Furthermore, utilizing the structure of the board holder 100 as described above, it is more advantageous to implement a system in which the process of mounting the source board 70 on the bottom chassis 13 is automated by a machine.

The board holder 100 may include a guide portion 140 configured to guide the source board 70 to enter the interior of the board holder 100. The guide portion 140 may be connected to the connection portion 130. The guide portion 140 may extend from one end of the connection portion 130 opposite to the holder body 110. The guide portion 140 may extend from one end of the connection portion 130 opposite to the bottom chassis 13. Specifically, the guide portion 140 may extend to face outwardly as it extends away from the connection portion 130. The extension direction of the guide portion 140 may be inclined relative to the extension direction of the connection portion 130.

To correspond to the number of the connection portions 130, the guide portion 140 may be provided in a plurality. For example, the guide portion 140 may include a first guide portion 140a connected to the first connection portion 130a and a second guide portion 140b connected to the second connection portion 130b. The first guide portion 140a may extend from the first connection portion 130a in a direction away from the holder body 110 and the second guide portion 140b. The second guide portion 140b may extend from the second connection portion 130b in a direction away from the holder body 110 and the first guide portion 140a.

As such, by including the guide portion 140 in the board holder 100, the process of mounting the source board 70 on the board holder 100 may be performed more efficiently and easily.

The configurations of the board holder 100 described above, including the holder body 110, the connection portion 130, the catch portion 120, the guide portion 140, and the pressing portion 150, may be integrally formed with each other. For example, the board holder 100 may be integrally formed by injecting a plastic resin.

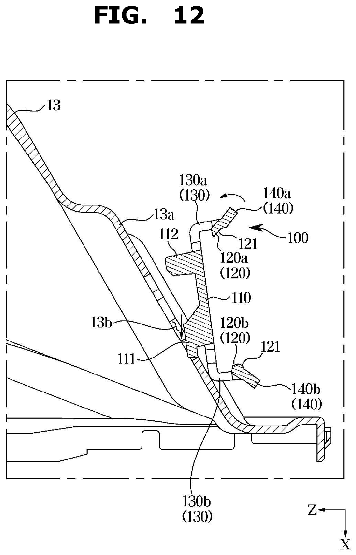

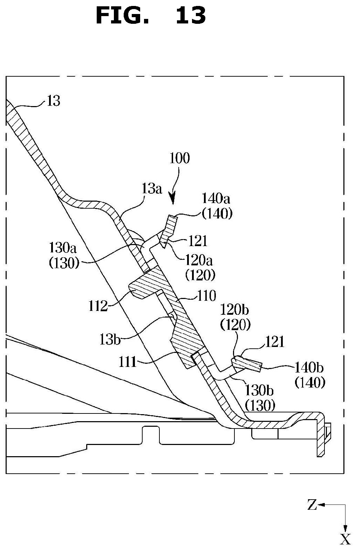

FIG. 12 is a cross-sectional view illustrating an example of a process of coupling a board holder to a bottom chassis of a display apparatus according to an embodiment of the present disclosure. FIG. 13 is a cross-sectional view illustrating a state in which the board holder is coupled to the bottom chassis by the process of FIG. 12.

An example of a method of coupling the board holder 100 to the bottom chassis 13 will be described with reference to FIGS. 12 and 13.

Referring to FIGS. 12 and 13, the board holder 100 may be coupled to the edge portion 13a of the bottom chassis 13. The coupling hole 13b may be formed in the edge portion 13a of the bottom chassis 13, and the board holder 100 may be coupled to the bottom chassis 13 by the first chassis coupling portion 111 and the second chassis coupling portion 112 penetrating the coupling hole 13b.

More specifically, as shown in FIG. 12, first, the first chassis coupling portion 111 may be positioned to penetrate the coupling hole 13b, and then may be catch-coupled to the coupling hole 13b. Thereafter, the second chassis coupling portion 112 may be positioned to penetrate the coupling hole 13b. With such steps, the board holder 100 may be coupled to the bottom chassis 13, as shown in FIG. 13.

As shown in FIGS. 12 and 13, the board holder 100 may be positioned such that the first chassis coupling portion 111 is closer to the lower edge of the bottom chassis 13 than the second chassis coupling portion 112 is.

In an embodiment, the edge portion 13a of the bottom chassis 13 may be formed to be inclined relative to the display panel 20. Under such a structure, when the process of coupling the board holder 100 to the bottom chassis 13 is performed with the rear surface of the bottom chassis 13 facing upwardly on a worktable, the first chassis coupling portion 111 may penetrate downwardly through the coupling hole 13b and become caught in the coupling hole 13b. From the perspective of an operator performing the task of coupling the board holder 100 to the bottom chassis 13, the method of allowing the first chassis coupling portion 111 to penetrate downwardly through the coupling hole 13b and become caught in the coupling hole 13b may be performed more conveniently than a method of allowing the first chassis coupling portion 111 to penetrate upwardly through the coupling hole 13b and become caught in the coupling hole 13b, thereby improving efficiency in the manufacturing process.

It should be appreciated that, as described above, the edge portion 13a of the bottom chassis 13 may be formed in line with the display panel 20.

The method of coupling the board holder 100 to the bottom chassis 13 described above with reference to FIGS. 12 and 13 is merely an example, and the concept of the present disclosure is not limited thereto.

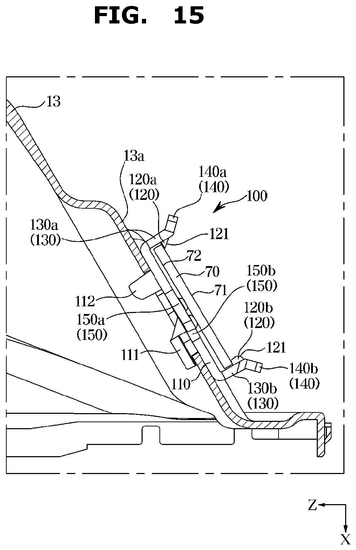

FIG. 14 is a view illustrating an example of a process of mounting a source board to a board holder of a display apparatus according to an embodiment of the present disclosure. FIG. 15 is a view illustrating a state in which the source board is mounted to the board holder by the process of FIG. 14.

An example of a method of mounting the source board 70 to the board holder 100 will be described with reference to FIGS. 14 and 15.

Referring to FIGS. 14 and 15, the source board 70 may be mounted on the board holder 100 held to the bottom chassis 13. More specifically, as shown in FIG. 14, the process of mounting the source board 70 to the board holder 100 may be performed through a process in which the source board 70 is not simultaneously caught by the first catch portion 120a and the second catch portion 120b, but is first caught by the second catch portion 120b and then caught by the first catch portion 120a. The board holder 100 may be positioned such that the second catch portion 120b is closer to the lower edge of the bottom chassis 13 than the first catch portion 120a is.

In an embodiment, the edge portion 13a of the bottom chassis 13 may be formed to be inclined relative to the display panel 20. Under such a structure, when performing the process of mounting the source board 70 to the board holder 100 with the rear surface of the bottom chassis 13 facing upward on a worktable, it may be more convenient from the perspective of an operator to first insert one side of the source board 70 into the inner side of the second catch portion 120b such that the source board 70 is caught by the second catch portion 120b positioned below, and then press the first catch portion 120a positioned above with the source board 70 to insert the other side of the source board 70 into the inner side of the first catch portion 120a so that the source board 70 is also caught by the first catch portion 120a, thereby improving efficiency in the manufacturing process.

In contrast to the inclined surface 121 of the first catch portion 120a having the shape of a flat surface, the inclined surface 121 of the second catch portion 120b disposed adjacent to the lower edge of the bottom chassis 13 may have the shape of curved surface. Thus, in the process of first inserting one side of the source board 70 into the inner side of the second catch portion 120b such that the source board 70 is caught by the second catch portion 120b, the one side of the source board 70 may smoothly move along the inclined surface of the first catch portion 120a, and may be efficiently inserted into the inner side of the second catch portion 120b.

With such steps, the source board 70 may be mounted to the board holder 100, as shown in FIG. 15.

Of course, as described above, the edge portion 13a of the bottom chassis 13 may be formed in line with the display panel 20.

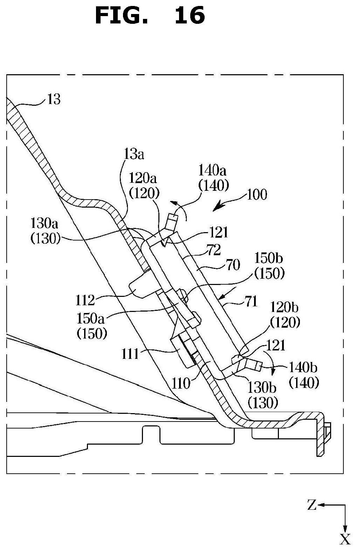

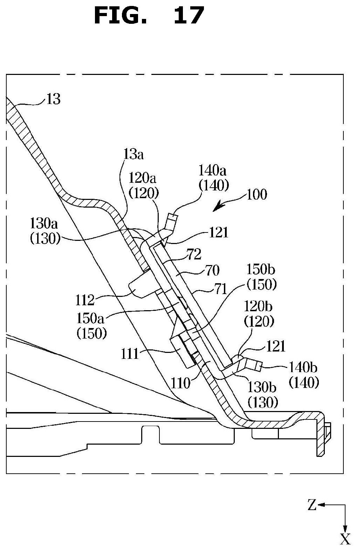

FIG. 16 is a view illustrating another example of a process of mounting a source board to a board holder of a display apparatus according to an embodiment of the present disclosure. FIG. 17 is a view illustrating a state in which the source board is mounted to the board holder by the process of FIG. 16.

Another example of a method of mounting the source board 70 to the board holder 100 will be described with reference to FIGS. 16 and 17.

Referring to FIGS. 16 and 17, the source board 70 may be mounted on the board holder 100 secured to the bottom chassis 13. In this case, unlike what was described with reference to FIGS. 14 and 15, the process of mounting the source board 70 to the board holder 100 may performed through a process in which the source board 70 is caught by the first catch portion 120a and the second catch portion 120b at approximately the same time.

More specifically, as shown in FIG. 16, the source board 70 may enter the inner side of the board holder 100 while moving in a direction substantially perpendicular to the edge portion 13a of the bottom chassis 13 or the holder body 110. Upon entering the inner side of the board holder 100, the source board 70 may press the first catch portion 120a and the second catch portion 120b at approximately the same time. As the source board 70 presses the first catch portion 120a and the second catch portion 120b, the first connection portion 130a and the second connection portion 130b may be elastically deformed outwardly at approximately the same time, and the source board 70 may be inserted into the inner side of the first catch portion 120a and the second catch portion 120b.

With such processes, the source board 70 may be mounted to the board holder 100, as shown in FIG. 17.

In the above, an embodiment in which the source board 70 is secured to the bottom chassis 13 by the board holder 100 has been described in detail with reference to FIGS. 1 to 17. However, the concept of the present disclosure is not limited thereto, and the structure described above may be modified and applied as a structure for securing various circuit boards, including the main board 50 and the power supply board 60, to the bottom chassis 13 using the board holder 100.

Furthermore, in the above embodiments, the board holder 100 is disposed on the edge portion 13a of the bottom chassis 13, but the board holder 100 may be disposed at various positions on the bottom chassis 13 depending on the type of circuit board that the board holder 100 is intended to secure to the bottom chassis 13 and its designed position.

The display apparatus according to an embodiment of the present disclosure may include a display panel, a source board configured to control the display panel, a bottom chassis configured to support the source board, and a board holder configured to secure the source board to the bottom chassis. The board holder may include a holder body secured to the bottom chassis, a catch portion connected to the holder body and configured to support one surface of the source board opposite to the bottom chassis, and a pressing portion connected to the holder body, configured to be elastically deformed to move relative to the holder body when an external force is applied, and configured to press the other surface of the source board facing the bottom chassis toward the catch portion.

The pressing portion may be configured to press the source board in a direction away from the bottom chassis.

The pressing portion may include a fixed end connected to the holder body, and a free end opposite to the fixed end and movable relative to the holder body. The other surface of the source board may be pressed by the free end.

The pressing portion may extend from the fixed end to the free end in a direction away from the bottom chassis.

The board holder may further include a gap formed between the free end and the holder body.

The catch portion may be configured to be movable relative to the holder body when an external force is applied to the catch portion.

The board holder may further include a connection portion connecting the holder body and the catch portion, and extending from the holder body in a direction away from the bottom chassis. The connection portion may be configured to be elastically deformable when an external force is applied to the catch portion.

The source board may be disposed in an inward direction with respect to the connection portion. The catch portion may protrude in the inward direction from the connection portion.

The connection portion may be configured to bend outwardly when an external force in a direction toward the holder body is applied to the catch portion.

The catch portion may include an inclined surface extending to face in the inward direction as it approaches the holder body. The inclined surface may be positioned to be opposite to the one surface of the source board.

The catch portion may include a first catch portion and a second catch portion disposed to face each other. The pressing portion may include a first pressing portion and a second pressing portion disposed to face each other.

The first pressing portion may extend from a first fixed end connected to the holder body to a first free end opposite to the first fixed end and movable relative to the holder body. The second pressing portion may extend from a second fixed end connected to the holder body to a second free end opposite to the second fixed end and movable relative to the holder body. The first fixed end may be more adjacent to the first catch portion among the first catch portion and the second catch portion. The second fixed end may be more adjacent to the second catch portion among the first catch portion and the second catch portion.

The first free end may be more adjacent to the second catch portion among the first catch portion and the second catch portion. The second free end may be more adjacent to the first catch portion among the first catch portion and the second catch portion.

The board holder may further include a first connection portion connecting the first pressing portion and the holder body, and configured to be elastically deformed such that the first catch portion moves in a direction away from the second catch portion when the first catch portion is pressed in a direction toward the bottom chassis, and a second connection portion connecting the second pressing portion and the holder body, and configured such that the second catch portion moves in a direction away from the first catch portion when the second catch portion is pressed in a direction toward the bottom chassis.

The first catch portion and the second catch portion may be disposed to face each other in a first direction. The first pressing portion and the second pressing portion may be disposed to face each other in a second direction perpendicular to the first direction.

The display apparatus according to an embodiment of the present disclosure may include a display panel, a circuit board configured to control the display panel, a bottom chassis configured to support the display panel and the circuit board, and a board holder disposed on the bottom chassis and to which the circuit board is mounted. The board holder may include a first catch portion configured to support one surface of the circuit board opposite to the bottom chassis, a second catch portion opposing the first catch portion and configured to support the one surface of the circuit board, a first pressing portion configured to be elastically deformable and to press the other surface of the circuit board in a direction away from the bottom chassis, and a second pressing portion opposing the first pressing portion, provided to be elastically deformable, and configured to press the other surface of the circuit board in a direction away from the bottom chassis.

The first catch portion may be configured to move in a direction away from the second catch portion when pressed in a direction toward the bottom chassis. The second catch portion may be configured to move in a direction away from the first catch portion when pressed in a direction toward the bottom chassis.

The board holder may further include a holder body secured to the bottom chassis. The first pressing portion may extend from a first fixed end connected to the holder body and adjacent to the first catch portion to a first free end opposite to the first fixed end and movable relative to the holder body. The second pressing portion may extend from a second fixed end connected to the holder body and adjacent to the second catch portion to a second free end opposite to the second fixed end and movable relative to the holder body.

The board holder may include a holder body secured to the bottom chassis, a first connection portion connecting the first pressing portion and the holder body and extending from the holder body in a direction away from the bottom chassis, and a second connection portion connecting the second pressing portion and the holder body and extending from the holder body in a direction away from the bottom chassis. The first connection portion may be configured to be elastically deformable when an external force is applied to the first catch portion. The second connection portion may be configured to be elastically deformable when an external force is applied to the second catch portion.

The display apparatus according to an embodiment of the present disclosure may include a display panel, a circuit board configured to control the display panel, a bottom chassis configured to support the circuit board, and a board holder configured to secure the circuit board to the bottom chassis. The board holder may include a holder body secured to the bottom chassis, a catch portion configured to be elastically deformed to be movably supported on the holder body when an external force is applied, and provided to support one surface of the circuit board, and a pressing portion configured to be elastically deformed to be movable relative to the holder body when an external force is applied, and provided to press the other surface of the circuit board toward the catch portion.

According to the concept of the present disclosure, the display apparatus may include the board holder that allows the circuit board to mount to the bottom chassis, and the board holder may include the pressing portion configured to be elastically deformable and to press the circuit board toward the catch portion, so that circuit boards of various thicknesses may be mounted to the bottom chassis.

According to the concept of the present disclosure, the display apparatus may include the board holder that allows the circuit board to mount to the bottom chassis, and the board holder may include the pressing portion configured to be elastically deformable and to press the circuit board toward the catch portion, so that the circuit board may be reliably secured.

According to the concept of the present disclosure, the display apparatus may include the board holder that allows the circuit board to mount to the bottom chassis, and the catch portion of the board holder supporting the circuit board may be configured to bend outwardly when an external force is applied, so that the process of mounting the circuit board to the bottom chassis may be efficiently and easily performed.

According to the concept of the present disclosure, the display apparatus may include the board holder that allows the circuit board to mount to the bottom chassis, and the catch portion of the board holder supporting the circuit board may be configured to bend outwardly when an external force is applied, so that the process of mounting the circuit board to the bottom chassis may be automated.

The effects of the concept of the present disclosure are not limited to the above-mentioned effects, and other unmentioned effects can be clearly understood by those skilled in the art from the description below.

While the present disclosure has been particularly described with reference to exemplary embodiments, it should be understood by those skilled in the art that various changes in form and details may be made without departing from the spirit and scope of the present disclosure as defined by the following claims.

## Claims

1. A display apparatus, comprising:
a display panel;
a source board configured to control the display panel;
a bottom chassis configured to support the source board; and
a board holder configured to secure the source board to the bottom chassis,
wherein the board holder comprises:
a holder body secured to the bottom chassis;
a catch portion connected to the holder body and configured to support one surface of the source board opposite to the bottom chassis; and
a pressing portion connected to the holder body, configured to be elastically deformed to move relative to the holder body when an external force is applied, and configured to press another surface of the source board facing the bottom chassis toward the catch portion.

2. The display apparatus of claim 1, wherein the pressing portion is configured to press the source board in a direction away from the bottom chassis.

3. The display apparatus of claim 1, wherein the pressing portion comprises:
a fixed end connected to the holder body; and
a free end opposite to the fixed end and movable relative to the holder body,
wherein the another surface of the source board is pressed by the free end.

4. The display apparatus of claim 3, wherein the pressing portion extends from the fixed end to the free end in a direction away from the bottom chassis.

5. The display apparatus of claim 3, wherein the board holder further comprises a gap formed between the free end and the holder body.

6. The display apparatus of claim 1, wherein the catch portion is configured to be movable relative to the holder body when an external force is applied to the catch portion.

7. The display apparatus of claim 6, wherein the board holder further comprises:
a connection portion connecting the holder body and the catch portion, and extending from the holder body in a direction away from the bottom chassis,
wherein the connection portion is configured to be elastically deformable when an external force is applied to the catch portion.

8. The display apparatus of claim 7, wherein
the source board is disposed in an inward direction with respect to the connection portion, and
wherein the catch portion protrudes in the inward direction from the connection portion.

9. The display apparatus of claim 8, wherein the connection portion is configured to bend outwardly when an external force in a direction toward the holder body is applied to the catch portion.

10. The display apparatus of claim 8, wherein
the catch portion comprises an inclined surface extending to face in the inward direction as the catch portion approaches the holder body, and
the inclined surface is positioned to be opposite to the one surface of the source board.

11. The display apparatus of claim 1, wherein
the catch portion comprises a first catch portion and a second catch portion disposed to face each other, and
the pressing portion comprises a first pressing portion and a second pressing portion disposed to face each other.

12. The display apparatus of claim 11, wherein
the first pressing portion extends from a first fixed end connected to the holder body to a first free end opposite to the first fixed end and movable relative to the holder body,
the second pressing portion
extends from a second fixed end connected to the holder body to a second free end opposite to the second fixed end and movable relative to the holder body,
the first fixed end is more adjacent to the first catch portion among the first catch portion and the second catch portion, and
the second fixed end is more adjacent to the second catch portion among the first catch portion and the second catch portion.

13. The display apparatus of claim 12, wherein
the first free end is more adjacent to the second catch portion among the first catch portion and the second catch portion, and
the second free end is more adjacent to the first catch portion among the first catch portion and the second catch portion.

14. The display apparatus of claim 11, wherein the board holder further comprises:
a first connection portion connecting the first pressing portion and the holder body, and configured to be elastically deformed such that the first catch portion moves in a direction away from the second catch portion when the first catch portion is pressed in a direction toward the bottom chassis; and
a second connection portion connecting the second pressing portion and the holder body, and configured such that the second catch portion moves in a direction away from the first catch portion when the second catch portion is pressed in a direction toward the bottom chassis.

15. The display apparatus of claim 11, wherein
the first catch portion and the second catch portion are disposed to face each other in a first direction, and
the first pressing portion and the second pressing portion are disposed to face each other in a second direction perpendicular to the first direction.
